# EUROPÄISCHE PATENTSCHRIFT

(11) **EP 1 442 486 B1**
(45) Veröffentlichungstag und Bekanntmachung des Hinweises auf die Patenterteilung: **21.06.2006**
(21) Anmeldenummer: 02787542.6
(22) Anmeldetag: 02.11.2002
(51) Int. Cl.: H01L 51/44

(54) **SOLARZELLE MIT ORGANISCHEM MATERIAL IN DER PHOTOVOLTAISCHEN SCHICHT SOWIE VERFAHREN ZU DEREN HERSTELLUNG**
SOLAR CELL WITH ORGANIC MATERIAL IN THE PHOTOVOLTAIC LAYER AND METHOD FOR THE PRODUCTION THEREOF
PILE SOLAIRE A MATERIAU ORGANIQUE DANS LA COUCHE PHOTOVOLTAIQUE ET PROCEDE DE FABRICATION ASSOCIE

(30) Priorität: 10.11.2001 DE 10155346
(43) Veröffentlichungstag der Anmeldung: 04.08.2004
(73) Patentinhaber: Fraunhofer-Gesellschaft zur Förderung der angewandten Forschung e.V., 80686 München (DE)
(72) Erfinder: HINSCH, Andreas, 79104 Freiburg (DE); GEORG, Andreas, 79104 Freiburg (DE); NIGGEMANN, Michael, 79102 Freiburg (DE)
(74) Vertreter: Rösler, Uwe
(86) Internationale Anmeldenummer: PCT/EP2002/012241
(87) Internationale Veröffentlichungsnummer: WO 2003/043100

(56) Entgegenhaltungen:
- WO-A-01/59854
- WO-A-97/10617
- DE-A- 3 013 991
- US-A- 3 969 746
- US-B1- 6 239 355
- FROMHERZ T ET AL: "Comparison of photovoltaic devices containing various blends of polymer and fullerene derivatives" SOLAR ENERGY MATERIALS AND SOLAR CELLS, ELSEVIER SCIENCE PUBLISHERS, AMSTERDAM, NL, Bd. 63, Nr. 1, Juni 2000 (2000-06), Seiten 61-68, XP004201247 ISSN: 0927-0248 in der Anmeldung erwähnt

## Beschreibung

### Technisches Gebiet

Die Erfindung bezieht sich auf eine Solarzelle sowie deren Herstellverfahren mit wenigstens einer aus organischem, insbesondere polymeren Material bestehenden photovoltaischen Schicht, die Licht absorbiert und in der Elektron-Loch Paare erzeugbar sind, mit zwei sich gegenüberliegenden Schichtoberflächen, von denen die eine mit wenigstens einer innerhalb der photovoltaischen Schicht erzeugten Löcher aufnehmenden Schicht und die andere mit wenigsten seiner innerhalb der photovoltaischen Schicht erzeugten Elektronen aufnehmenden Schicht verbunden ist, sowie mit Elektrodenbereichen, von denen ein Elektrodenbereich mit der Löcher aufnehmenden Schicht und der andere Elektrodenbereich mit der Elektronen aufnehmenden Schicht elektrisch kontaktiert ist.

### Stand der Technik

Solarzellen der vorstehend genannten Gattung, die anstelle einer aus Halbleitermaterial bestehenden photoempfindlichen Schicht eine organische, vorzugsweise polymere Materialschicht vorsehen, vermögen derzeit zwar nicht Wirkungsgrade von typischerweise 20% von konventionellen Solarzellen zu erzielen, vielmehr betragen die mit den bisherigen polymeren Solarzellen erreichbaren Wirkungsgrade etwas über 2%, doch zeichnen sich eben jene, neuartige organische Solarzellen durch ihre überaus preisgünstigen Materialien und Herstellungsmöglichkeiten aus, wodurch sie zunehmend ins wirtschaftliche Interesse rücken. Gelingt es künftig den Wirkungsgrad polymerer Solarzellen weiter zu steigern, bei unverändert preisgünstigen bzw. preisgünstigeren Herstellungsverfahren, so könnte die wirtschaftliche Attraktivität organischer Solarzellen jene von konventionellen Solarzellen übertreffen, sofern es gelingt, die Anschaffungs- und Betriebskosten im Verhältnis zur erzeugbaren elektrischen Leistung organischer Solarzellen geringer zu halten als im Vergleich zur Kosten-Nutzen-Bilanz konventioneller Solarzellen.

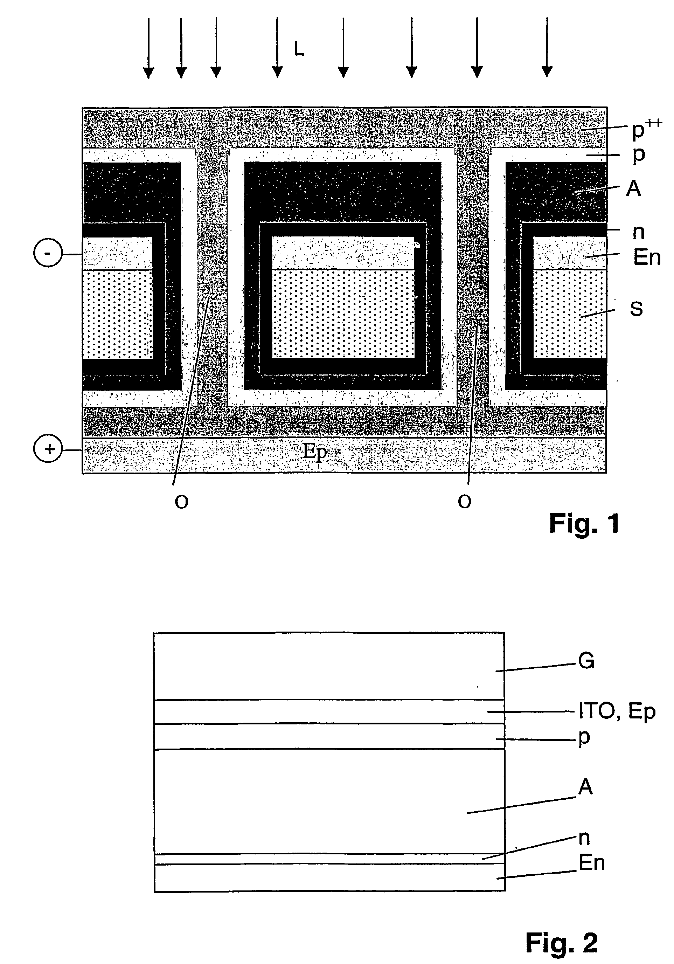

Ein typischer Aufbau einer polymeren Solarzelle ist der Fig. 2 zu entnehmen. Die solarzellenaktive Schicht A, in der Sonnenlicht absorbiert und Elektron-Lochpaare erzeugt werden, besteht aus einer Mischung aus Polymeren, wie beispielsweise PPV, Poly-Para-Phenylen-Vinylen oder Polytiophen-Derivaten, und Fulleren-Derivaten, wie beispielsweise C₆₀. Zur Aufnahme der innerhalb der das Sonnenlicht absorbierenden photoaktiven Schicht A erzeugten Elektronen und Löcher ist diese mit einer löcheraufnehmenden Schicht p, vorzugsweise ebenfalls bestehend aus einem Polymer, wie beispielsweise PEDOT, sowie mit einer Elektronen aufnehmenden Schicht n, bestehend vorzugsweise aus LiF verbunden. Zur Verbesserung der Leitfähigkeit auf der "Löcherseite" der Absorptionsschicht A über der p-Schicht ist eine lichttransparente elektrisch leitende ITO-Schicht (Zinn-dotiertes Indiumoxid) aufgebracht. Letztlich dient als Trägersubstrat eine Glasplatte G.

Alternative organische, vorzugsweise polymere Materialien, die für den Einsatz in Solarzellen mit dem vorstehend beschriebenen Aufbau geeignet sind, können dem Beitrag von T. Fromherz et al., in Solar Energy Materials and Solar Cells, Bd. 63, Seiten 61-68, Jahrgang 2000, entnommen werden.

Zur elektrischen Kontaktierung des vorstehend beschriebenen, bekannten Solarzellenaufbaus dient eine metallische, vorzugsweise Aluminium-Elektrode En, die mit der n-Schicht kontaktiert ist sowie eine seitliche, elektrische Kontaktierung der ITO-Schicht. Als entscheidenden Nachteil vorstehend beschriebener polymerer Solarzelle ist die Verwendung der ITO-Schicht zu nennen, zumal ITO selbst als teures Material bekannt ist, das darüberhinaus im Wege eines technisch aufwendigen Abscheideverfahrens, beispielsweise durch Verwendung von PVD (physical vaper deposition), Aufdampf- oder Sputterverfahren, abgeschieden wird. Vorstehende Verfahren setzen allesamt Vakuumbedingungen voraus, zu deren Realisierung kapitalintensive Maßnahmen zu treffen sind, wodurch das Herstellverfahren hohe Investitionen erfordert. Dem angestrebten Ziel, möglichst kostengünstige Solarzellen herzustellen und anzubieten, steht somit gezielt die Verwendung einer ITO-Schicht unvermeidbar im Wege.

Andere Solarzellen mit organischer photovoltaischer Schicht werden z.B. in US-B1-6 239 355 und WO-A1-01/59854 offenbart.

### Darstellung der Erfindung

Der Erfindung liegt die Aufgabe zugrunde, eine gattungsgemäße organische, vorzugsweise polymere Solarzelle aus möglichst preisgünstigen Materialien sowie unter Verwendung technologisch einfacher und somit kostengünstiger Herstellverfahren herzustellen. Auf die Verwendung teurer Materialien soll verzichtet werden und darüberhinaus soll der mit den bisherigen polymeren Solarzellen erzielbare Wirkungsgrad zumindest erreicht, wenn nicht sogar verbessert werden. Den erfindungsgemäßen Maßnahmen liegt das übergeordnete Ziel zugrunde, polymere Solarzellen unter wirtschaftlichen Gesichtspunkten herzustellen und somit alternative Solarzellen mit einer wirtschaftlichen Attraktivität anbieten zu können, die der Attraktivität konventioneller Solarzellen auf der Basis von Halbleitermaterialien zumindest gleichkommt.

Die Lösung der der Erfindung zugrundeliegenden Aufgabe mit im Anspruch 1 angegeben. Ein erfindungsgemäßes Verfahren ist Gegenstand des Anspruches 21. Alternative Lösungen sind in den Ansprüchen 19 sowie 33 enthalten.
Den Erfindungsgedanken vorteilhaft weiterbildende Merkmale sind Gegenstand der Unteransprüche sowie der Beschreibung, insbesondere unter Bezugnahme auf die Ausführungsbeispiele und den Figuren zu entnehmen.

Die erfindungsgemäße Solarzelle nach dem Oberbegriff des Anspruches 1 zeichnet sich dadurch aus, dass die die Elektronen aufnehmende Schicht über ihren Elektrodenbereich mit einem, eine Vorder- und Rückseite aufweisenden Flächensubstrat verbunden ist, wobei das Flächensubstrat von der Vorder- zur Rückseite lateral durchragende Öffnungsstrukturen aufweist.

In einer bevorzugten Ausführungsform besteht das Flächensubstrat aus einem porösen Material mit das Flächensubstrat vollständig durchsetzende Poren, beispielsweise in Form einer porösen Kunststofffolie oder auch aus einem Textil- oder Zellulosematerial bestehenden Trägerschicht, wie Papier. Ferner ist die Ausbildung des Flächensubstrates auch als eine Oberflächen-behandelte Metallfolie denkbar, die einer thermischen Behandlung unterzogen und anschließend einseitig poliert worden ist, so dass zumindest eine Seite der metallischen Oberfläche, nämlich ihre Vorderseite, mit einer elektrischen isolierenden Schicht, beispielsweise einer Oxidschicht, überzogen ist.

Ferner ist auf der die Elektronen aufnehmenden Schicht die photovoltaische Schicht und auf dieser die Löcher aufnehmende Schicht aufgebracht. Alle vorstehenden, auf der Vorderseite des Flächensubstrates aufgebrachten Schichten weisen einzeln und in der Summe Schichtdicken auf, so dass wenigstens einzelne Öffnungsstrukturen das Flächensubstrat sowie die Schichtenfolgen lateral offen durchragen.

In einer ersten erfindungsgemäßen Ausführungsform ist auf der die Löcher aufnehmenden Schicht zusätzlich eine elektrisch leitfähige, beispielsweise durch Dotierung stark Löcher leitende Schicht (im folgenden p⁺⁺-Schicht genannt) derart aufgebracht, dass das p⁺⁺-Schichtmaterial die das Flächensubstrat samt Schichtaufbau laterial durchragenden Öffnungsstrukturen bis hin zur Rückseite des Flächensubstrats wenigstens teilweise ausfüllt. Auf diese Weise kann sichergestellt werden, dass durch entsprechendes Vorsehen eines auf der Rückseite des Flächensubstrates aufgebrachten Elektrodenbereiches die vorderseitig auf dem Flächensubstrat aufgebrachte p⁺⁺-Schicht zur Rückseite des Flächensubstrates elektrisch durchkontaktierbar ist.

Eine zweite alternative Ausführungsform der Solarzelle sieht vor, die auf der photovoltaischen Schicht unmittelbar aufgebrachten, die Löcher aufnehmende Schicht selbst als p⁺⁺-Schicht auszuführen, wobei das p⁺⁺-Schichtmaterial die bislang, das Flächensubstrat lateral offen durchragenden Öffnungsstrukturen vorzugsweise vollständig, aber zumindestens teilweise ausfüllt, so dass eine elektrische Kontaktierung der p⁺⁺-Schicht hin zur Rückseite des Flächensubstrates durch geeignetes Vorsehen eines Elektrodenbereiches an der Rückseite des Flächensubstrates möglich ist.

Sowohl der mit der Elektronen aufnehmenden Schicht verbundene Elektrodenbereich als auch der mit der Löcher aufnehmenden Schicht verbundene Elektrodenbereich bestehen aus Metall, vorzugsweise aus Aluminium. Beide Elektrodenbereiche befinden sich durch die Rückseitenkontaktierung der erfindungsgemäßen Solarzelle auf der in Bestrahlungsrichtung der Solarzelle hinter der photovoltaischen Schicht, wodurch Abschattungseffekte durch die Elektrodenbereiche vollständig vermieden werden können. Lediglich ist dafür Sorge zu tragen, dass jene Schichtmaterialien, die der photovoltaischen Schicht in Strahlungsrichtung vorgelagert sind, dies betrifft ausschließlich die die Löcher aufnehmende Schicht sowie die p⁺⁺-Schicht bzw. ausschließlich die p⁺⁺-Schicht, möglichst lichtdurchlässig sein sollten, um möglichst geringe bzw. keine Absorptionsverluste innerhalb der der photovoltaischen Schicht vorgelagerten Schichten zu erleiden. In bevorzugter Weise weist die die Löcher aufnehmende Schicht bzw. die p⁺⁺-Schicht eine Lichttransmission für photovoltaisch verwertbares Sonnenlicht von mindestens 50%, bevorzugt 70%, besonders bevorzugt von 80% auf. Die vorstehend angegebenen Transmissionswerte beziehen sich auf das Faltungsintegral von Sonnenlichtintensität (AM 1.5) sowie die spektrale Empfindlichkeit des photovoltaischen Absorbermaterials, aus dem die photovoltaische Schicht aufgebaut ist. Besonders geeignete Materialien für die die Löcher aufnehmende Schicht bzw. die p⁺⁺-Schicht stellen Polythiophene oder Polythiophen-Derivate dar. Ein besonders bevorzugtes Material stellt ein Produkt der Fa. Bayer und betrifft 3,4 Polyethylendioxithiophen, das auch unter dem von der Fa. Bayer geschützten Produktnamen "Baytron (R)" zu beziehen ist.

Neben der erhobenen Forderung, dass das die Löcher leitende Schichtmaterial sowie auch die p⁺⁺-Schicht möglichst lichttransparent sein sollte, um das Sonnenlicht möglichst verlustarm in die photovoltaische Schicht zu übertragen, besteht darüberhinaus die Forderung, dass das in den Öffnungsstrukturen befindliche p⁺⁺⁻Schichtmaterial eine möglichst hohe Leitfähigkeit zu dem auf der Rückseite des Flächensubstrates aufgebrachten Elektrodenbereich aufweisen sollte. Innerhalb der Öffnungsstrukturen spielt jedoch die erste Forderung bezüglich einer möglichst hohen Lichttransmission keine Rolle, so dass innerhalb dieser Bereiche zusätzliche, die Leitfähigkeit verbessernde Materialien gezielt eingebracht werden können, beispielsweise Graphit, Metalle oder dotierte Zink- oder Zinnoxide, wie etwa Antimon oder dotiertes Zinnoxid. Derartige Materialien können im Extremfall vollständig, lichtundurchlässig sein, jedoch verfügen sie über eine deutlich bessere elektrische Leitfähigkeit als das zumindest teiltransparente p⁺⁺-Schichtmaterial.

Soll aus Kostengründen auf eine zusätzliche Beigabe vorstehender, die Leitfähigkeit erhöhende Materialien, verzichtet werden, ist es vorteilhaft, die Breite bzw. Durchmesser der Öffnungsstrukturen größer auszulegen, als die auf der photovoltaischen Schicht aufgebrachte Schichtdicke, der die Löcher aufnehmende Schicht sowie p⁺⁺-Schicht. Eine derartige Maßnahme einer möglichst reduzierten Schichtdickenausbildung der p⁺⁺-Schicht sowie gegebenenfalls die Löcher aufnehmenden Schicht auf der photovoltaischen Schicht und zugleich eine möglichst weite Ausbildung der Öffnungsstrukturen, die mit p⁺⁺-Schichtmaterial an- bzw,. ausgefüllt sind, verhilft die Transmission der p⁺⁺-Schicht einerseits zu senken, jedoch andererseits die Leitfähigkeit längs der Öffnungsstrukturen zu erhöhen.

Demgegenüber wäre eine grenzenlose Optimierung der Leitfähigkeit des innerhalb der Öffnungsstrukturen befindlichen Materials oder Materialmischung kritisch in Bezug auf die Ausbildung lokaler Kurzschlüsse innerhalb der Öffnungsstrukturen zwischen dem unmittelbar auf dem Flächensubstrat befindlichen Elektrodenbereich für die Ableitung von Elektronen und der p⁺⁺-Schicht über der photovoltaischen Schicht. Eine grenzenlose Optimierung der Leitfähigkeit des p⁺⁺-Materials oberhalb der Absorberschicht wäre analog kritisch in Bezug auf die Ausbildung lokaler Kurzschlüsse zwischen dem unmittelbar auf dem Flächensubstrat befindlichen Elektrodenbereich für die Ableitung von Elektronen En und der p⁺⁺-Schicht über der photovoltaischen Schicht außerhalb der Öffnungsstrukturen.

Ein Vorteil des Aufbaus der erfindungsgemäßen Solarzelle ist somit die Unempfindlichkeit gegenüber der vorstehend beschriebenen Kurzschlüsse bzw. den sogenannten pinholes. Hierbei wirken sich durch die begrenzte Leitfähigkeit der Löcher leitenden Schicht lokale Kurzschlüsse in den Öffnungsstrukturen bzw. außerhalb der Öffnungsstrukturen nicht so gravierend aus, wie bei Solarzellen mit elektrisch besser leitenden Materialien. Ist ein Kurzschluß zwischen dem Elektrodenbereich auf dem Substrat, der die Elektronen ableitet, und der p⁺⁺-Schicht über dem Absorber, welche die Löcher ableitet, eingetreten, so muß der elektrische Strom bei der erfindungsgemäßen Solarzelle immer noch einen Serienwiderstand entsprechend der Leitung durch das Löcher leitende Material in den Öffnungsstrukturen bzw. außerhalb der Öffnungsstrukturen überwinden. Beispielsweise entspricht dieser Widerstand bei einem typischen Durchmesser der Öffnungsstrukturen von 10 µm, einer typischen Höhe bzw. Länge von 100 µm und einer elektrischen Leitfähigkeit gemäß den Anforderungen, wie im weiteren ausgeführt wird (R2=2x10⁴ Ohm für ein quadratisches Flächenelement) 60x10³ Ohm. Beurteilt man einen Gesamtwiderstand von mehreren, parallelen Kurzschlüssen von 1000 Ohm bezogen auf eine Fläche von einem cm² als tolerabel, so entspricht dies einer tolerierbaren Kurzschlußdichte von 60 pro cm². Beträgt beispielsweise der typische laterale Abstand der Öffnungsstrukturen ca. 100µm, so entspricht dies etwa einem Kurzschluss pro 167 Öffnungen. Beträgt beispielsweise der typische laterale Abstand der Öffnungsstrukturen ca. 10µm, so entspricht dies etwa einem Kurzschluss pro 2 Öffnungen. Für R2=2x10⁵ Ohm ergibt sich entsprechend einer tolerierbaren Kurzschlußdichte von 600 pro cm², für R2=8x10³ Ω, 24 pro cm2, für R2=2x10³ Ohm 6 pro cm².

Ein weiterer Aspekt für eine möglichst optimierte geometrisch und elektrische Auslegung der Solarzelle betrifft die Forderung, dass der durch die Bestrahlung der Solarzelle hervorgerufene ohm'sche Spannungsabfall längs der Öffnungsstrukturen sehr viel kleiner sein soll, als die Betriebsspannung der Solarzelle am Arbeitspunkt, an dem die Solarzelle ihre maximale Leistung besitzt. Vorzugsweise sollte der ohm'sche Spannungsabfall längs der Öffnungsstrukturen weniger als 5% der Spannung der Solarzelle am Arbeitspunkt maximaler Leistung betragen. Hieraus leiten sich einerseits bestimmte Größen und Vorgaben für den elektrischen Widerstand der p⁺⁺-Schicht in Bestrahlungsrichtung vor der photovoltaischen Schicht als auch des diesbezüglichen Materials innerhalb der Öffnungsstrukturen ab, zum anderen Vorgaben für die geometrische Anordnung und Ausbildung der einzelnen Öffnungsstrukturen innerhalb des Flächensubstrates. Auf nähere Details hierzu wird auf die Beschreibung unter Bezugnahme auf die Ausführungsbeispiele verwiesen.

Ferner wird ein erfindungsgemäßes Verfahren zur Herstellung einer Solarzelle mit wenigstens einer aus organischem, insbesondere polymerem Material bestehenden photovoltaischen Schicht, der vorstehend genannten Art, beschrieben, das sich durch folgende Verfahrensschritte auszeichnet: In einem ersten Schritt wird ein, eine Vorder- und Rückseite aufweisendes Flächensubstrat, wie bereits eingangs erläutert, das insbesondere über Öffnungsstrukturen verfügt, die das Flächensubstrat von seiner Vorder- bis hin zur Rückseite vollständig durchragen, bereitgestellt. Das Flächensubstrat wird einseitig, nämlich an seiner Vorderseite, mit einem Elektrodenbereich versehen, indem die Vorderseite des Flächensubstrates metallisiert wird. Der Metallisierungsvorgang erfolgt beispielsweise im Rahmen eines nasschemischen Verfahrens, beispielsweise in einem Tauchbad. Ebenso ist es auch möglich, die flächige Metallisierung im Rahmen eines Aufdampf- oder Aufsputterverfahrens durchzuführen.

Um eine Beschichtung bzw. Metallisierung der Rückseite des Flächensubstrates zu vermeiden, ist diese gegen den Metallisierungsprozess zu schützen. Beispielsweise bietet sich hierfür eine auf die Rückseite des Flächensubstrates aufbringbare Schutzfolie an, die von der Rückseite wieder leicht entfernt werden kann.

Nach erfolgtem Metallisieren der Vorderseite des Flächensubstrates wird eine elektronenselektive Schicht auf den abgeschiedenen Elektrodenbereich flächig aufgebracht, die Elektronen gut, Löcher hingegen schlecht aufnimmt und an das Metall weitergibt. Beispielsweise eignet sich hierfür eine sehr dünne LiF-Schicht oder mit Al oder Cs dotiertem Bathophenantrolin. Auch diese Schicht kann mittels konventioneller Aufdampfprozesse, oder in einem nasschemischen Verfahren aufgebracht werden.

Auf die Elektronen-selektive Schicht erfolgt nun das Abscheiden einer photovoltaischen Schicht, die sogenannte Absorber-Schicht, die vorzugsweise aus einer Mischung aus einem Fulleren-Derivat und einem PPV-Polymer besteht. Grundsätzlich ist es jedoch auch möglich, alternative organische, insbesondere polymere photovoltaische Werkstoffe einzusetzen, wie sie beispielsweise aus der eingangs erwähnten Literaturstelle von T. Fromherz zu entnehmen sind.

In einer ersten alternativen Verfahrensvariante wird auf die abgeschiedene Absorberschicht, die im übrigen ebenfalls im Wege eines Tauchbades aufgebracht werden kann, um die Herstellungskosten niedrig zu halten, eine p-leitende Schicht, beispielsweise bestehend aus Polythiophen-Derivaten, die Löcher gut, Elektronen schlecht aufnimmt und Löcher leiten kann, aufgebracht. Auf diese Schicht wird letztlich eine stark dotierte p⁺⁺- Schicht, beispielsweise aus Polythiophen-Derivaten, die Löcher gut leitet, derart aufgebracht, dass das stark dotierte p⁺⁺-Schichtmaterial die das Flächensubstrat lateral durchsetzten Öffnungsstrukturen vorzugsweise vollständig ausfüllt und durch die jeweiligen Öffnungsstrukturen auf die Rückseite des Flächensubstrates dringt.

Auf diese Weise wird eine elektrische Durchkontaktierung der Solarzelle von der Vorderseite hin zur Rückseite des Flächensubstrates erzielt, so dass jegliche, die photovoltaische aktive Schicht der Solarzelle abschattende Elektrodenbereiche vermieden werden können. Zur Verbesserung der durch die Öffnungsstrukturen hindurchragenden elektrischen Kontakte hin zur Rückseite des Flächensubstrates eignen sich zudem auch Pasten, Lacke oder Lösungen, die eine elektrisch leitende Schicht aufbauen. Derartige Substanzen werden bevorzugt auf der Rückseite des Flächensubstrates aufgebracht und in die vorhandenen Öffnungsstrukturen bzw.

Poren verpresst, nachdem die eingangs erwähnte Schutzfolie von der Rückseite des Flächensubstrates abgezogen worden ist.

Ausgehend von dem vorstehend erwähnten Abscheideprozess zur Herstellung der photovoltaischen Schicht sieht eine zweite alternative Verfahrensweise vor, unmittelbar auf der photovoltaischen Schicht die p⁺⁺-Schicht aufzubringen, die wie vorstehend erwähnt, zumindest teilweise die Öffnungsstrukturen zu durchdringen vermag, um auf diese Weise eine Rückseitenkontaktierung zu realisieren.

Schließlich gilt es, unabhängig von den beiden vorstehend erwähnten Verfahrensvarianten, die Rückseite des Flächensubstrates mit einer Metallschicht zu versehen, die als Elektrodenbereich für die p⁺⁺-Schicht dient. Das Aufbringen der Metallschicht auf der Rückseite des Flächensubstrates erfolgt bevorzugt durch Aufdampfen oder insbesondere Aufkleben einer Metallfolie mit einem leitfähigen Kleber als Kontaktmittel. Diese Metallisierung weist vorteilhafterweise neben der elektrischen Leitung auch eine Barrierefunktion gegenüber dem Eindringen von Verunreinigungen, wie beispielsweise Sauerstoff oder Wasser, in das Solarzellensystem von ihrer Rückseite, auf.

In einer bevorzugten Ausführungsform ist es denkbar, innerhalb oder auf der p⁺⁺⁻Schicht dünne ITO-Schichten oder andere anorganische transparente elektrisch leitende Schichten aufzudampfen oder aufzusputtern. Um dem Kostenaspekt Rechnung zu tragen, können diese zusätzlichen Schichten durch ihre elektrische Kontaktierung durch das Flächensubstrat hindurch relativ dünn gewählt werden.

Die vorstehend genannten Verfahrensschritte zum Aufbringen der einzelnen Schichten auf ein, eine poröse Struktur aufweisendes Flächensubstrat, das vorzugsweise selbst über elastische Eigenschaften verfügt, wird besonders bevorzugt in einem sogenannten "Roll-to-Roll-Beschichtungsverfahren" (Rolle zu Rolle-Verfahren) hergestellt, wodurch die Produktionskosten entscheidend reduziert werden können. Hierbei wird das Flächensubstrat durch einzelne nasschemische Tauchbäder gezogen, durch die eine entsprechende Schichtabscheidung erfolgt. Als entscheidender Beschichtungsparameter ist hierbei die Geschwindigkeit, mit der das zu beschichtende Flächensubstrat durch die einzelnen Tauchbäder gezogen wird, durch die die einzelnen Schichtdicken bestimmt werden können.

Grundsätzlich ist es auch möglich, vorstehend beschriebene, organische Solarzelle derart aufzubauen, dass jeweils die n- und p-Schichten miteinander vertauscht sind. Entsprechend soll dann eine z.B. durch Dotierung stark Elektronen leitende Schicht n⁺⁺ genannt werden, und entsprechend sind auch p⁺⁺ und n⁺⁺ zu vertauschen. Diesen Gedanken folgend sind die Ansprüche 19 und 20 darauf gerichtet, eine Solarzelle mit vertauschten Leitungscharakteristika anzugeben, die ansonsten über den gleichen erfindungsgemäßen Solarzellenaufbau verfügt wie vorstehend beschrieben. Das gleiche gilt auch für die alternativ formulierten Verfahrensansprüche 33 und 34.

### Kurze Beschreibung der Erfindung

Die Erfindung wird nachstehend ohne Beschränkung des allgemeinen Erfindungsgedankens anhand eines Ausführungsbeispieles unter Bezugnahme auf die Zeichnungen exemplarisch beschrieben. Es zeigen:
- Fig. 1: schematisierter Querschnitt durch die Schichtenabfolge einer erfindungsgemäß ausgebildeten Solarzelle, sowie
- Fig. 2: schematisierter Querschnitt einer an sich bekannten organischen Solarzelle (Stand der Technik).

### Wege zur Ausführung der Erfindung, gewerbliche Verwendbarkeit

Fig. 1 zeigt einen Querschnitt durch eine erfindungsgemäß ausgebildete organische Solarzelle, mit einem Flächensubstrat S, das über eine poröse Struktur verfügt und das Flächensubstrat S lateral durchsetzende Öffnungsstrukturen O vorsieht. Eine Vielzahl derartiger Öffnungsstrukturen durchragen das Flächensubstrat S vollständig von ihrer Vorderseite bis hin zu ihrer Rückseite. Wie bereits erwähnt, eignen sich als poröse Flächensubstrate Papier, poröse Kunststofffolien oder auch oberflächenbehandelte Metallfolien.

Auf der Vorderseite des Flächensubstrates S ist ein als Metallschicht ausgebildeter Elektronenbereich En aufgebracht, der als Kathode für die im weiteren beschriebenen Solarzelle dient. Zumindest den Elektrodenbereich En vollständig überdeckend ist ferner eine Elektronen aufnehmende Schicht n vorgesehen, die z.B. bei naßchemischer Beschichtung herstellungsbedingt die gesamte Oberfläche des Elekirodenbereiches En sowie des Flächensubstrates S überdecken kann. Wie bereits eingangs erwähnt, erfolgt vorzugsweise die Schichtabscheidung im Wege eines Tauchbades, indem die gesamten freien Oberflächen mit dem abzuscheidenden Schichtmaterial benetzt werden. Die n-Schicht besteht vorzugsweise aus LiF. Auf dieser n-Schicht wird in einem weiteren Verfahrensprozess die photovoltaische Schicht A abgeschieden, auf der wiederum eine Löcher aufnehmende Schicht p vorgesehen ist, die letztlich von einer p⁺⁺⁻Schicht überdeckt ist.

Wesentlicher Gesichtspunkt der erfindungsgemäß ausgebildeten organischen Solarzelle ist die Durchkontaktierung der p⁺⁺-Schicht lateral durch den gesamten Schichtaufbau durch die Öffnungsstrukturen O hindurch auf die Rückseite der Solarzelle, an der ein weiterer Elektrodenbereich Ep, die Anode, vorgesehen ist.

Licht L, das auf die Vorderseite der Solarzelle auftrifft, durchdringt die nahezu transparenten Schichten p⁺⁺und p und dringt in die photovoltaische Absorberschicht A ein, in der Elektronen-Loch-Paare gebildet werden. Elektronen gelangen über die n-Schicht in den Elektrodenbereich En und bilden somit die Kathode der Solarzelle. Die innerhalb der photovoltaischen Schicht A abgetrennten Löcher gelangen hingegen über die p-Schicht in die p⁺⁺-Schicht und über die Öffnungsstrukturen O zum Elektrodenbereich Ep, der die Anode der Solarzelle bildet.

Da längs der Öffnungsstrukturen O die Lichttransmission des p⁺⁺-Schichtmaterials keine Rolle spielt, können in diesem Bereich Zusatzstoffe dem p⁺⁺-Schichtmaterial beigemengt werden, wodurch die Löcherleitfähigkeit erhöht werden kann. Derartige Zusatzstoffe sind beispielsweise Graphit, Metalle oder dotierte Zink- oder Zinnoxide, wie Antimon, dotiertes Zinnoxid oder ähnliche.

Im weiteren sei R1 der elektrische Widerstand eines quadratischen Flächenelementes der p⁺⁺-Schicht auf der photovoltaischen Schicht A, hingegen R2 der elektrische Widerstand eines quadratischen Flächenelementes desjenigen Materials, das sich innerhalb der Öffnungsstrukturen befindet. Ld sei der durchschnittliche Abstand zweier Öffnungsstrukturen, wobei h die typische Dicke des Flächensubstrates und damit in etwa die typische Länge der Öffnungsstrukturen beträgt. b sei der typische Durchmesser der Öffnungen und I eine typische Bestrahlungsstärke des Lichtes, das auf die organische Solarzelle auftrifft.

Soll der ohm'sche Spannungsabfall längs einer Öffnungsstruktur kleiner als 5% der Spannung der organischen Solarzelle am Arbeitspunkt maximaler Leistung, am sogenannten maximum power point, betragen und gelten für die vorstehenden Parameter folgende Werte: Ld = 100 µm, b = 10 µm, h = 100 µm und 1 = 1000 W/m², so folgt für die Widerstände R1 und R2: R1 ≤2 x 10⁵ Ohm und R2 ≤2x10⁴ Ohm.

Da der laterale Abstand zweier Öffnungsstrukturen aus praktischen Gründen merklich größer ist als der Durchmesser der Öffnungsstrukturen, ist der maximale tolerierbare Wert für R1 größer als der von R2, falls der Durchmesser der Öffnungen kleiner ist als die Dicke des Flächensubstrates bzw. die Länge der Öffnungen. Entsprechend vorteilhaft ist es, die Verwendung eines im Vergleich zur p⁺⁺-Schicht auf dem Absorber dickeren oder anderen Materials in den Öffnungen einen geringeren Widerstand vorzusehen. Aus der nachstehenden Tabelle können bevorzugte Werte für vorstehende Parameter entnommen werden:

| Ld (*µ*m) | b (µm) | H (*µ*m) | (W/qm²) | R1 (Ohm) | R2 (Ω) |
|---|---|---|---|---|---|
| 500 | 100 | 100 | 1000 | 5x10⁶ | 8x10³ |
| 500 | 10 | 100 | 1000 | 5 x 10⁶ | 8 x 10² |
| 100 | 1 | 100 | 1000 | 2 x 10⁵ | 2 x 10³ |
| 30 | 3 | 100 | 1000 | 2 x 10⁶ | 6 x 10⁴ |
| 10 | 1 | 100 | 1000 | 2 x 10⁷ | 2 x 10⁵ |
| 10 | 0,1 | 100 | 1000 | 2x10⁷ | 2x10⁴ |

Bevorzugte Anwendungsfelder für die erfindungsgemäß ausgebildete Solarzelle ist einerseits die Bestrahlung der Solarzelle mit hohen Lichtintensitäten, wie sie z.B. bei direkter Sonnenbestrahlung auftreten. Lichtintensitäten zwischen 100 W/m² und 1000 W/m² sind bei Außenanwendungen durchaus typisch. Andererseits vermag die Solarzelle auch bei geringeren Lichtintensitäten, wie sie z.B. bei indirekter Sonnenbestrahlung oder Bestrahlung mit Kunstlicht auftreten, beachtliche Leistungen zeigen, z.B. bei Innenanwendungen mit Lichtintensitäten von kleiner als 100 W/m². Geringere Bestrahlungsintensitäten reduzieren dabei zusätzlich die Anforderungen an die elektrische Leitfähigkeit der einzelnen Schichten im Solarzellen-System.

## Patentansprüche

1. Solarzelle mit wenigstens einer aus organischem, insbesondere polymeren Material bestehenden photovoltaischen Schicht (A), die Licht absorbiert und in der Elektron-Loch Paare erzeugbar sind, mit zwei sich gegenüberliegenden Schichtoberflächen, von denen die eine mit wenigstens einer innerhalb der photovoltaischen Schicht (A) erzeugten Löcher aufnehmenden Schicht (p) und die andere mit wenigstens einer innerhalb der photovoltaischen Schicht (A) erzeugten Elektronen aufnehmenden Schicht (n) verbunden ist, sowie mit Elektrodenbereichen En und Ep, von denen ein Elektrodenbereich (Ep) mit der Löcher aufnehmenden Schicht (p) und der andere Elektrodenbereich (En) mit der Elektronen aufnehmenden Schicht (n) elektrisch kontaktiert ist,
**dadurch gekennzeichnet, dass** die die Elektronen aufnehmende Schicht (n) über ihren Elektrodenbereich (En) mit einem, eine Vorder- und Rückseite aufweisenden Flächensubstrat (S) verbunden ist,
dass das Flächensubstrat (S) von der Vorder- zur Rückseite lateral durchragende Öffnungsstrukturen (O) aufweist,
dass die die Löcher aufnehmende Schicht (p), die photovoltaische Schicht (A), die die Elektronen aufnehmende Schicht (n) sowie der mit der Schicht (n) verbundene Elektrodenbereich (En) derart auf der Vorderseite des Flächensubstrats (S) aufgebracht sind, dass wenigstens einzelne Öffnungsstrukturen das Flächensubstrat (S) sowie das aus den Schichten En, n, A, und p bestehende Schichtsystem lateral durchragen,
dass eine elektrisch leitfähige p⁺⁺-Schicht auf der die Löcher aufnehmenden Schicht (p) aufgebracht ist oder die die Löcher aufnehmende Schicht (p) als p⁺⁺-Schicht ausgebildet ist, die die das Flächensubstrat (S) lateral durchragenden Öffnungsstrukturen (O) bis hin zur Rückseite des Flächensubstrat (S) wenigstens teilweise ausfüllt, und
dass der Elektrodenbereich (Ep) für die die Löcher aufnehmende Schicht (p) auf der Rückseite des Flächensubstrats (S) vorgesehen ist, der in elektrischen Kontakt mit der durch die Öffnungsstrukturen (O) hindurchreichenden p⁺⁺-Schicht steht.

2. Solarzelle nach Anspruch 1,
**dadurch gekennzeichnet, dass** innerhalb wenigstens einzelner Öffnungsstrukturen (O) ein Löcher leitendes Material enthalten ist, das eine bessere elektrische Leitfähigkeit aufweist als das Schichtmaterial, aus der die p⁺⁺-Schicht besteht.

3. Solarzelle nach Anspruch 1 oder 2,
**dadurch gekennzeichnet, dass** die elektrische Leitfähigkeit des Löcher leitenden Materials innerhalb der Öffnungsstrukturen derart gering gewählt ist, dass mögliche Kurzschlüsse innerhalb der Öffnungsstrukturen zwischen dem Elektronen aufnehmenden Elektrodenbereich (En) und der p⁺⁺-Schicht den Kurzschlußstrom und/oder den Wirkungsgrad der Solarzelle nicht wesentlich beeinträchtigt.

4. Solarzelle nach einem der Ansprüche 1 bis 3,
**dadurch gekennzeichnet, dass** die elektrische Leitfähigkeit des Löcher leitenden Materials (p) außerhalb der Öffnungsstrukturen derart gering gewählt ist, dass mögliche Kurzschlüsse außerhalb der Öffnungsstrukturen zwischen dem Elektronen aufnehmenden Elektrodenbereich (En) und der p⁺⁺-Schicht den Kurzschlußstrom und/oder den Wirkungsgrad der Solarzelle nicht wesentlich beeinträchtigt.

5. Solarzelle nach einem der Ansprüche 1 bis 4,
**dadurch gekennzeichnet, dass** die Elektrodenbereiche als Metallschichten ausgebildet sind.

6. Solarzelle nach einem der Ansprüche 1 bis 5,
**dadurch gekennzeichnet, dass** die p⁺⁺-Schicht einen elektrischen Widerstand von höchstens 10⁶ Ω, bevorzugt zwischen 10⁵ und 10² Ω, besonders bevorzugt zwischen 10³ und 10⁴ Ω aufweist.

7. Solarzelle nach einem der Ansprüche 1 bis 6,
**dadurch gekennzeichnet, dass** die p⁺⁺-Schicht eine Lichttransmission für photovoltaisch verwertbares Sonnenlichtes von mindestens 50%, bevorzugt 70%, besonders bevorzugt 80% aufweist.

8. Solarzelle nach einem der Ansprüche 1 bis 7,
**dadurch gekennzeichnet, dass** die p⁺⁺-dotierte Schicht Polythiopene oder Polythiophen Derivate enthält.

9. Solarzelle nach einem der Ansprüche 1 bis 8,
**dadurch gekennzeichnet, dass** innerhalb der Öffnungsstrukturen (O) eingebrachtes, die Löcher leitendes p⁺⁺-Schichtmaterial, Graphit, Metalle oder dotierte Zink- oder Zinnoxide, wie Antimon dotiertes Zinnoxid oder Aluminium dotiertes Zinkoxidenthält.

10. Solarzelle nach einem der Ansprüche 1 bis 9,
**dadurch gekennzeichnet, dass** das Flächensubstrat (S) aus einem porösem Material besteht mit Poren, die die das Flächensubstrat (S) lateral durchragende Öffnungsstrukturen (O) bilden.

11. Solarzelle nach einem der Ansprüche 1 bis 10,
**dadurch gekennzeichnet, dass** die Öffnungsstrukturen (O) Öffnungsdurchmesser im Bereich von 1 bis 10 µm vorsehen und benachbarte Öffnungsstrukturen (O) einen gegenseitigen Abstand zwischen 10 und 100 µm aufweisen, oder
dass die Öffnungsstrukturen (O) Öffnungsdurchmesser im Bereich von 0,1 bis 1 µm vorsehen und benachbarte Öffnungsstrukturen einen gegenseitigen Abstand zwischen 1 und 10µm aufweisen, oder
dass die Öffnungsstrukturen (O) Öffnungsdurchmesser im Bereich von 10 bis 100 µm vorsehen und benachbarte Öffnungsstrukturen einen gegenseitigen Abstand zwischen 100 und 500 µm aufweisen, oder
dass die Öffnungsstrukturen (O) Öffnungsdurchmesser im Bereich von 5 bis 25 µm besitzen und benachbarte Öffnungsstrukturen (O) einen gegenseitigen Abstand zwischen 25 und 100 µm aufweisen.

12. Solarzelle nach einem der Ansprüche 1 bis 11,
**dadurch gekennzeichnet, dass** die auf der Vorderseite des Flächensubstrates (S) vorhandene Schichtabfolge bestehend aus dem Elektrodenbereich (En), der Elektronen aufnehmenden Schicht (n), die photovoltaische Schicht (A) eine Gesamtschichtdicke aufweist, die kleiner als die Hälfte des Öffnungsdurchmessers der Öffnungsstrukturen (O) ist oder im Falle, dass zusätzlich zu der die Löcher aufnehmenden Schicht (p) eine p⁺⁺-Schicht vorgesehen ist, zur vorstehenden Gesamtschichtdicke die Dicke der Löcher aufnehmenden Schicht (p) mitzuberücksichtigen ist.

13. Solarzelle nach einem der Ansprüche 1 bis 12,
**dadurch gekennzeichnet, dass** das Flächensubstrat (S) aus einem porösen Kunststoff, aus Textil oder aus Cellulosematerial, wie Papier, oder einer oberflächenbehandelten Metallfolie besteht.

14. Solarzelle nach einem der Ansprüche 1 bis 13,
**dadurch gekennzeichnet, dass** das Flächenmaterial elastisch ist.

15. Solarzelle nach einem der Ansprüche 1 bis 14,
**dadurch gekennzeichnet, dass** die photovoltaische Schicht (A) polymeres Material oder polymere Materialzusammensetzungen enthält.

16. Solarzelle nach einem der Ansprüche 1 bis 15,
**dadurch gekennzeichnet, dass** die photovoltaische Schicht (A) eine Mischung aus Fulleren-Derivat und einem PPV-Polymer enthält.

17. Solarzelle nach einem der Ansprüche 1 bis 16,
**dadurch gekennzeichnet, dass** die die Elektronen aufnehmende Schicht (n) eine LiF-Schicht oder eine Al-dotierte oder Cs-dotierte Bathophenantrolin-Schicht ist.

18. Solarzelle nach einem der Ansprüche 1 bis 17,
**dadurch gekennzeichnet, dass** die Elektrodenbereiche (En, Ep) aus Aluminium bestehen.

19. Solarzelle nach dem Oberbegriff des Anspruches 1,
**dadurch gekennzeichnet, dass** die die Löcher aufnehmende Schicht (p) über ihren Elektrodenbereich (Ep) mit einem, eine Vorder- und Rückseite aufweisenden Flächensubstrat (S) verbunden ist, das das Flächensubstrat (S) von der Vorder- zur Rückseite lateral durchragende Öffnungsstrukturen (O) aufweist,
dass die die Elektronen aufnehmende Schicht (n), die photovoltaische Schicht (A), die die Löcher aufnehmende Schicht (p) sowie der mit der Schicht (p) verbundene Elektrodenbereich (Ep) derart auf der Vorderseite des Flächensubstrats (S) aufgebracht sind, dass wenigstens einzelne Öffnungsstrukturen das Flächensubstrat (S) sowie das aus den Schichten Ep, p, A, und n bestehende Schichtsystem lateral durchragen,
dass eine elektrisch leitfähige n⁺⁺-Schicht auf der die Elektronen aufnehmenden Schicht (n) aufgebracht ist oder die die Elektronen aufnehmende Schicht (n) als n⁺⁺⁻Schicht ausgebildet ist, die die das Flächensubstrat (S) lateral durchragenden Öffnungsstrukturen (O) bis hin zur Rückseite des Flächensubstrat (S) wenigstens teilweise ausfüllt, und
dass der Elektrodenbereich (En) für die die Elektronen aufnehmende Schicht (n) auf der Rückseite des Flächensubstrats (S) vorgesehen ist, der in elektrischen Kontakt mit der durch die Öffnungsstrukturen (O) hindurchreichenden n⁺⁺ -Schicht steht.

20. Solarzelle nach Anspruch 19,
**dadurch gekennzeichnet, dass** die Merkmale der Ansprüche 2-7, 9-16 sowie 18 einzeln oder in Kombination derart anwendbar sind, dass die in den genannten Ansprüchen angegebenen elektrisch leitenden Schichtmaterialien (n), (En), (p), (Ep), (p⁺⁺) in ihrer Leitungsnatur zu invertieren sind.

21. Verfahren zur Herstellung einer Solarzelle mit wenigstens einer aus organischem, insbesondere polymeren Material bestehenden photovoltaischen Schicht,
**gekennzeichnet durch** die Verfahrensschritte:
- Bereitstellen eines eine Vorder- und eine Rückseite aufweisenden Flächensubstrats (S), das lateral das Flächensubstrat (S) von der Vorder- zur Rückseite durchragende Öffnungsstrukturen (O) aufweist,
- Aufbringen eines Elektrodenbereiches (En) auf die Vorderseite des Flächensubstrats (S),
- flächiges Aufbringen einer Elektronen aufnehmenden Schicht (n) auf den Elektrodenbereich (En) auf der Vorderseite des Flächensubstrats (S),
- flächiges Aufbringen der photovoltaischen Schicht (A) auf die die Elektronen aufnehmende Schicht (n),
- flächiges Aufbringen einer Löcher aufnehmenden Schicht (p) oder Aufbringen einer p⁺⁺-Schicht auf die photovoltaische Schicht (A) derart, bzw. flächiges Aufbringen einer p⁺⁺-Schicht im Falle des Vorsehens einer Löcher aufnehmenden Schicht (p) auf dieser derart, dass die das Flächensubstrat (S) lateral durchragenden Öffnungsstrukturen (O) bis hin zur Rückseite des Flächensubstrats (S) mit dem p⁺⁺ -Schichtmaterial ausgefüllt werden und
- Aufbringen eines weiteren Elektrodenbereiches (Ep) auf die Rückseite des Flächensubstrats (S), so daß die p⁺⁺-Schicht mit dem weiteren Elektrodenbereich (Ep) **durch** die Öffnungsstrukturen (O) kontaktiert ist.

22. Verfahren nach Anspruch 21,
**dadurch gekennzeichnet, dass** zusätzlich zu dem p⁺⁺-Schichtmaterial ein elektrisch leitendes Material in die Öffnungsstrukturen eingebracht wird, so daß dieses die p⁺⁺-Schicht und den Elektrodenbereich (Ep) auf der Rückseite des Flächensubstrates (S) kontaktiert.

23. Verfahren nach einem der Ansprüche 21 oder 22,
**dadurch gekennzeichnet, dass** der Elektrodenbereich (En), die Elektronen aufnehmende Schicht (n), die photovoltaische Schicht (A), die Löcher aufnehmende Schicht (p), die p⁺⁺-Schicht und/oder der Elektrodenbereich (Ep) mittels Aufdampfen, Aufsputtern oder naß-chemischen Verfahren aufgebracht wird.

24. Verfahren nach einem der Ansprüche 21 bis 23,
**dadurch gekennzeichnet, dass** auf die Rückseite des Flächensubstrats (S) eine Folie aufgebracht wird, noch bevor das Flächensubstrat (S) beschichtet wird, und dass die Folie von der Rückseite des Flächensubstrats (S) vor Aufbringen des weiteren Elektrodenbereiches (Ep) auf der Rückseite von dieser entfernt wird.

25. Verfahren nach einem der Ansprüche 21 bis 24,
**dadurch gekennzeichnet, dass** das Kontaktieren der in den das Flächensubstrat (S) lateral von der Vorder- zur Rückseite durchragenden Öffnungsstrukturen (O) befindlichen p⁺⁺-Schichtmaterial mit dem Elektrodenbereich (Ep) auf der Rückseite des Flächensubstrats (S) durch Pasten, Lacke oder Lösungen unterstützt wird.

26. Verfahren nach Anspruch 25 ,
**dadurch gekennzeichnet, dass** die Lacke, Pasten oder Lösungen elektrisch leitend sind und die Öffnungstrukturen (O) zumindest teilweise durchdringen und eine elektrisch leitende Verbindung zur p⁺⁺-Schicht herstellten.

27. Verfahren nach einem der Ansprüche 21 bis 26,
**dadurch gekennzeichnet, dass** auf und/oder innerhalb der p⁺⁺-Schicht wenigstens eine dünne ITO-Schicht (Zinn-dotiertes Indiumoxid) und/oder eine anorganische transparente elektrisch leitende Schicht vorgesehen wird.

28. Verfahren nach Anspruch 27,
**dadurch gekennzeichnet, dass** die ITO-Schicht und/oder die anorganische transparente elektrisch leitende Schicht aufgedampft oder aufgesputtert wird.

29. Verfahren nach einem der Ansprüche 21 bis 28,
**dadurch gekennzeichnet, dass** das Aufbringen des Elektrodenbereiches (Ep) auf der Rückseite des Flächensubstrats (S) durch Aufdampfen oder Aufkleben einer Metallfolie erfolgt.

30. Verfahren nach Anspruch 29,
**dadurch gekennzeichnet, dass** ein elektrisch leitfähiger Kleber für das Aufkleben der Metallfolie verwendet wird.

31. Verfahren nach Anspruch 30 ,
**dadurch gekennzeichnet, dass** der elektrisch leitfähige Kleber die Öffnungsstrukturen (O) zumindest teilweise durchdringt und eine leitende Verbindung zur p++ Schicht herstellt.

32. Verfahren nach einem der Ansprüche 21 bis 31,
**dadurch gekennzeichnet, dass** das Flächensubstrat (S) durch Abrollen von einer ersten Rolle bereitgestellt wird und nach Durchführung aller Verfahrensschritte die gewonnene Solarzellen auf eine zweite Rolle aufgerollt werden.

33. Verfahren nach dem Oberbegriff des Anspruches 21
**gekennzeichnet durch** die Verfahrensschritte:
- Bereitstellen eines eine Vorder- und eine Rückseite aufweisenden Flächensubstrats (S), das lateral das Flächensubstrat (S) von der Vorder- zur Rückseite durchragende Öffnungsstrukturen (O) aufweist,
- Aufbringen eines Elektrodenbereiches (Ep) auf die Vorderseite des Flächensubstrats (S),
- flächiges Aufbringen einer Löcher aufnehmenden Schicht (p) auf den Elektrodenbereich (Ep) auf der Vorderseite des Flächensubstrats (S),
- flächiges Aufbringen der photovoltaischen Schicht (A) auf die die Löcher aufnehmende Schicht (p),
- flächiges Aufbringen einer Elektronen aufnehmenden Schicht (n) oder Aufbringen einer n⁺⁺-Schicht auf die photovoltaische Schicht (A) derart, bzw. flächiges Aufbringen einer n⁺⁺ -Schicht im Falle des Vorsehens einer Elektronen aufnehmenden Schicht (n) auf dieser derart, dass die das Flächensubstrat (S) lateral durchragenden Öffnungsstrukturen (O) bis hin zur Rückseite des Flächensubstrats (S) mit dem n⁺⁺-Schichtmaterial ausgefüllt werden und
- Aufbringen eines weiteren Elektrodenbereiches (En) auf die Rückseite des Flächensubstrats (S), so daß die n⁺⁺-Schicht mit dem weiteren Elektrodenbereich (En) **durch** die Öffnungsstrukturen (O) kontaktiert ist.

34. Verfahren nach Anspruch 33,
**dadurch gekennzeichnet, dass** die Merkmale der Ansprüche 22-26 sowie 29-32 derart anwendbar sind, dass die in den genannten Ansprüchen angegebenen elektrisch leitenden Schichtmaterialien (n), (En), (p), (Ep), (p⁺⁺) in ihrer Leitungsnatur zu invertieren sind.

## Claims

1. A solar cell having at least one photovoltaic layer (A) made of an organic material, in particular a polymer material, which absorbs light and in which electron-hole pairs can be produced, said solar cell having two opposite layer surfaces of which one is connected with at least one hole-receiving layer (p) produced inside said photovoltaic layer (A) and the other is connected with at least one electron-receiving layer (n) produced inside said photovoltaic layer (A), as well as having electrode areas En and Ep, of which one said electrode area (Ep) is electrically contacted to said hole-receiving layer (p) and the other said electrode area (En) is electrically connected to said electron receiving layer (n),
**wherein**
- said electron-receiving layer (n) is connected via its electrode area (En) to a flat substrate (S) having a front side and a rear side,
- said flat substrate (S) is provided with opening structures (O) projecting laterally through from said front side to said rear side,
- said hole-receiving layer (p), said photovoltaic layer (A), said electron-receiving layer (n) and said electrode area (En) connected to said layer (n) are applied on said front side of said flat substrate (S) in such a manner that at least single said opening structures project laterally through said flat substrate (S) and through said layer system comprising said layers En, n, A, and p,
- an electrically conducting p⁺⁺ layer is applied onto said hole-receiving layer (p) or said hole-receiving layer (p) is designed as a p⁺⁺ layer which at least partially fills said opening structures (O) projecting laterally through said flat substrate (S) to said rear side of said flat substrate (S), and
- said electrode area (Ep) for receiving said hole-receiving layer (p) is provided on said rear side of said flat substrate (S), said electrode area (Ep) being electrically contacted to said p⁺⁺ layer reaching through said opening structures (O).

2. A solar cell according to claim 1,
**wherein** a hole-conducting material, which has better electrical conductivity than the layer material of which said p⁺⁺ layer is made, is contained inside at least single opening structures (O).

3. A solar cell according to claim 1 or 2,
wherein the electrical conductivity of said hole-conducting material inside said opening structures is selected so low that possible short circuits inside said opening structures between said electron-receiving electrode area (En) and said p⁺⁺ layer do not significantly impair the short circuit current and/or the efficiency of said solar cell.

4. A solar cell according to one of the claims 1 to 3,
wherein the electrical conductivity of said hole-conducting material (p) outside said opening structures is selected so low that possible short circuits outside said opening structures between said electron-receiving electrode area (En) and said p⁺⁺ layer do not significantly impair the short circuit current and/or the efficiency of said solar cell.

5. A solar cell according to one of the claims 1 to 4,
wherein said electrode areas are designed as metal layers.

6. A solar cell according to one of the claims 1 to 5,
wherein said p⁺⁺ layer has a maximum electrical resistance of 10⁶ Ω, preferably between 10⁵ and 10² Ω, particularly preferably between 10³ and 10⁴ Ω.

7. A solar cell according to one of the claims 1 to 6,
wherein said p⁺⁺ layer has a light transmission for photovoltaic useable sunlight of at least 50%, preferably 70%, particularly preferably 80%.

8. A solar cell according to one of the claims 1 to 7,
wherein said doped p⁺⁺ layer contains polythiophenes or polythiophene derivatives.

9. A solar cell according to one of claims 1 to 8,
wherein the hole-conducting p⁺⁺ layer material introduced inside said opening structures (O) contains graphite, metals or doped zinc oxides or doped tin oxides, such as antimony- doped tin oxide or aluminum-doped zinc oxide.

10. A solar cell according to one of the claims 1 to 9,
wherein said flat substrate (S) is made of a porous material having pores which form said opening structures (O) projecting laterally through said flat substrate (S).

11. A solar cell according to one of the claims 1 to 10,
wherein
- said opening structures (O) provide opening diameters in the range from 1 to 10µm and adjacent said opening structures (O) are spaced between 10 and 100µm apart, or
- said opening structures (O) provide openings diameters in the range from 0.1 to 1µm and adjacent said opening structures (O) are spaced between 1 and 10µm apart, or
- said opening structures (O) provide opening diameters in the range from 10 to 100µm and adjacent said opening structures (O) are spaced between 100 and 500 µm apart, or
- said opening structures (O) have opening diameters in the range from 5 to 25 µm and adjacent said opening structures (O) are spaced between 25 and 100 µm apart.

12. A solar cell according to one of the claims 1 to 11,
wherein the present sequence of layers on said front side of said flat substrate (S) comprising said electrode area (En), said electron-receiving layer (n), said photovoltaic layer (A) have an overall thickness which is less than half of the opening diameter of said opening structures (O) or in case a p⁺⁺ layer is provided in addition to said hole-receiving layer (p), the thickness of said hole-receiving layer (p) must be taken into account in said overall layer thickness.

13. A solar cell according to one of the claims 1 to 12,
wherein said flat substrate (S) is made of a porous plastic, textile or cellulose material, such as paper, or a surface-treated metal foil.

14. A solar cell according to one of the claims 1 to 13,
wherein said surface substrate material is elastic.

15. A solar cell according to one of the claims 1 to 14,
**wherein** said photovoltaic layer (A) contains polymer material or polymer material compounds.

16. A solar cell according to one of the claims 1 to 15,
**wherein** said photovoltaic layer (A) contains a mixture of a fullerene derivative and a PPV polymer.

17. A solar cell according to one of the claims 1 to 16,
**wherein** said electron-receiving layer (n) is a LiF layer or an Al-doped or Cs-doped bathophenanthroline layer.

18. A solar cell according to one of the claims 1 to 17,
wherein said electrode areas (En, Ep) are made of aluminum.

19. A solar cell according to the generic part of claim 1,
**wherein**
- said hole-receiving layer (p) is connected via its electrode area (Ep) to a flat substrate (S) having a front side and a rear side,
- said flat substrate (S) has opening structures (O) projecting laterally through from said front side to said rear side,
- said electron-receiving layer (n), said photovoltaic layer (A), said hole-receiving layer (p) and said electrode area (Ep) connected to said layer (p) are applied onto said front side of said flat substrate (S) in such a manner that at least single opening structures (O) project laterally through said flat substrate (S) and through the layer system made of said layers Ep, p, A, and n,
- an electrically conducting n⁺⁺ layer is applied onto said electron-receiving layer (n) or said electron-receiving layer (n) is designed as a n⁺⁺ layer which at least partially fills said opening structures (O) projecting laterally through said flat substrate (S) to said rear side of said flat substrate (S), and
- said electrode area (En) for said electron-receiving layer (n) is provided on said rear side of said flat surface (S), said electrode area (En) being electrically contacted to said n⁺⁺ layer reaching through said opening structures (O).

20. A solar cell according to claim 19,
**wherein** the features of claims 2-7, 9-16 and 18 are singly or in combination useable in such a manner that the nature of the conductivity of said electrically conducting materials (n), (En), (p), (Ep), (p⁺⁺) cited in said claims must be inverted.

21. A method for producing a solar cell having at least one photovoltaic layer made of an organic material, in particular a polymer material,
**characterized by** the process steps:
- provision of a flat substrate (S) having a front side and a rear side, which is provided with opening structures (O) projecting laterally through said flat substrate (S) from said front side to said rear side,
- application of an electrode area (En) onto said front side of said flat substrate (S),
- two-dimensional application of an electron-receiving layer (n) onto said electrode area (En) on said front side of said flat substrate (S),
- two-dimensional application of said photovoltaic layer (A) onto said electron-receiving layer (n),
- two-dimensional application of a hole-receiving layer (p) or application of a p⁺⁺ layer onto said photovoltaic layer (A), respectively two-dimensional application of a p⁺⁺ layer in the case of the provision of a hole-receiving layer (p) on the latter, in such a manner that said opening structures (O) projecting laterally through said flat substrate (S) to said rear side of said flat surface (S) are filled with said p⁺⁺ layer material, and
- application of an additional electrode area (Ep) onto said rear side of said flat substrate (S) in such a manner that said p⁺⁺ layer is contacted to said additional electrode area (Ep) through said opening structures (O).

22. A method according to claim 21,
**wherein** in addition to said p⁺⁺ layer material, an electrically conducting material, is introduced into said opening structures in such a manner that said electrically conducting material contacts said p⁺⁺ layer as well as said electrode area (Ep) on said rear side of said flat substrate (S).

23. A method according to one of the claims 21 or 22,
**wherein** said electrode area (En), said electron-receiving layer (n), said photovoltaic layer (A), said hole-receiving layer (p), said p⁺⁺ layer and/or said electrode are (Ep) are applied by means of vapor deposition, sputtering or wet chemical processes.

24. A method according to one of the claims 21 to 23,
**wherein** a foil is applied onto said rear side of said flat substrate (S) before said flat substrate (S) is coated, and
said foil is removed from said rear side of said flat substrate (S) before applying said additional electrode area (Ep) onto said rear side of said flat substrate (S).

25. A method according to one of the claims 21 to 24,
**wherein** said contacting of said p⁺⁺ layer contained in said opening structures (O) projecting laterally through said flat substrate (S) from said front side to said rear side to said electrode area (Ep) on said rear side of said flat substrate (S) is supported by pastes, varnishes or solutions.

26. A method according to claim 25,
**wherein** said pastes, varnishes or solutions are electrically conducting and at least partially penetrate said opening structures (O) and produce an electrically conducting connection to said p⁺⁺ layer.

27. A method according to one of the claims 21 to 26,
**wherein** on and/or inside said p⁺⁺ layer, at least one thin ITO layer (doped indium tin oxide) and/or an inorganic transparent electrically conducting layer is provided.

28. A method according to claim 27,
**wherein** said ITO layer and/or said inorganic transparent electrically conducting layer are vapor deposited or sputtered on.

29. A method according to one of the claims 21 to 28,
**wherein** said application of said electrode area (Ep) onto said rear side of said flat substrate (S) occurs by means of vapor deposition or gluing on a metal foil.

30. A method according to claim 29,
**wherein** an electrically conductive adhesive is utilized for gluing on said metal foil.

31. A method according to claim 30,
**wherein** said electrically conductive adhesive at least partially penetrates said opening structures (O) and produces a conducting connection to said p⁺⁺ layer.

32. A method according to one of the claims 21 to 31,
**wherein** said flat substrate (S) is provided by being unrolled from a first roll and after execution of all said process steps, the yielded solar cell is rolled onto a second roll.

33. A method according to the generic part of claim 21,
**characterized by** the method steps:
- provision of a flat substrate (S) having a front side and a rear side, which is provided with opening structures (O) projecting laterally through said flat substrate (S) from said front side to said rear side,
- application of an electrode area (Ep) onto said front side of said flat substrate (S),
- two-dimensional application of a hole-receiving layer (p) onto said electrode area (Ep) on said front side of said flat substrate (S),
- two-dimensional application of said photovoltaic layer (A) onto said hole-receiving layer (p),
- two-dimensional application of an electron-receiving layer (n) or application of a n⁺⁺ layer onto said photovoltaic layer (A), respectively two-dimensional application of a n⁺⁺ layer in the case of the provision of an electron-receiving layer (n) on the latter, in such a manner that said opening structures (O) projecting laterally through said flat substrate (S) to said rear side of said flat surface (S) are filled with said n⁺⁺ layer material, and
- application of an additional electrode area (En) onto said rear side of said flat substrate (S) in such a manner that said n⁺⁺ layer is contacted to said additional electrode area (Ep) through said opening structures (O).

34. A method according to claim 21,
**wherein** the features of claims 22-26 and 29-32 can be applied in such a manner that said claims that the nature of the conductivity of said electrically conducting materials (n), (En), (p), (Ep), (p⁺⁺) cited in said claims must be inverted.

## Revendications

1. Cellule solaire comportant au moins une couche photovoltaïque organique (A), notamment composée de matière à base de polymère, qui absorbe la lumière et dans laquelle des paires de trous d'électrons peuvent être réalisées, comprenant deux surfaces de couches opposées, dont une est reliée à au moins une couche recevant des trous (p) réalisée dans la couche photovoltaïque (A) et l'autre est reliée à au moins une couche recevant des électrons (n) réalisée dans la couche photovoltaïque (A), ainsi que des plages d'électrode En et Ep, dont une plage d'électrode (Ep) est mise en contact électrique avec la couche (p) recevant les trous (p) et l'autre plage d'électrode (En) est mise en contact électrique avec la couche recevant les électrons (n),
**caractérisée en ce que** la couche recevant les électrons (n) est reliée par une plage d'électrode (En) à un substrat de surface (S) présentant une face avant et une face arrière,
que le substrat de surface (S) présente des structures d'ouvertures (O) traversant latéralement la face avant et la face arrière,
que la couche recevant les trous (p), la couche photovoltaïque (A), la couche recevant les électrons (n) ainsi que la plage d'électrode (En) reliée à la couche (n) sont appliquées sur la face avant du substrat de surface (S) de manière à ce qu'au moins certaines structures d'ouverture traversent latéralement le substrat de surface (S) ainsi que le système de couches formé des couches En, n, A et p,
qu'une couche p⁺⁺ conductrice d'électricité est appliquée sur la couche recevant les trous (p) ou que la couche recevant les trous (p) est réalisée sous forme de couche p⁺⁺ qui remplit du moins partiellement les structures d'ouvertures (O) traversant latéralement le substrat de surface (S) jusqu'à la face arrière du substrat de surface (S) et
que la plage d'électrode (Ep) pour la couche recevant les trous (p) est prévue sur la face arrière du substrat de surface (S) qui est en contact électrique avec la couche p⁺⁺ passant à travers les structures d'ouvertures (O).

2. Cellule solaire selon la revendication 1,
**caractérisée en ce que**, dans au moins certaines structures d'ouvertures (O), se trouve une matière conductrice de trous qui présente une meilleure conductivité électrique que la matière de couche dont la couche p⁺⁺ est faite.

3. Cellule solaire selon la revendication 1 ou 2,
**caractérisée en ce que** la conductivité électrique de la matière conductrice de trous est établie assez faible à l'intérieur des structures d'ouvertures pour que d'éventuels courts-circuits à l'intérieur des structures d'ouvertures entre la plage d'électrode (En) recevant les électrons et la couche p⁺⁺ n'affectent pas sensiblement le courant de court-circuit et/ou le degré d'efficacité de la cellule solaire.

4. Cellule solaire selon une des revendications 1 à 3,
**caractérisée en ce que** la conductivité électrique de la matière conductrice de trous (p) est établie assez faible à l'extérieur des structures d'ouvertures pour que d'éventuels courts-circuits à l'extérieur des structures d'ouvertures entre la plage d'électrode (En) recevant les électrons et la couche p⁺⁺ n'affectent pas sensiblement le courant de court-circuit et/ou le degré d'efficacité de la cellule solaire.

5. Cellule solaire selon une des revendications 1 à 4,
**caractérisée en ce que** les plages d'électrode sont réalisées sous forme de couches métalliques.

6. Cellule solaire selon une des revendications 1 à 5,
**caractérisée en ce que** la couche p⁺⁺ a une résistance électrique d'au plus 10⁶ Ω, de préférence de 10⁵ à 10² Ω, de manière particulièrement préférentielle de 10³ à 10⁴ Ω.

7. Cellule solaire selon une des revendications 1 à 6,
**caractérisée en ce que** la couche p⁺⁺ a une transmission de lumière pour la lumière solaire exploitable par voie photovoltaïque d'au moins 50 %, de préférence 70 %, de manière particulièrement préférentielle de 80 %.

8. Cellule solaire selon une des revendications 1 à 7,
**caractérisée en ce que** la couche additionnée de p⁺⁺ contient du polythiopène ou des dérivés de polythiopène.

9. Cellule solaire selon une des revendications 1 à 8,
**caractérisée en ce que** la matière de couche p⁺⁺ conductrice de trous intégrée à l'intérieur des structures d'ouvertures (O) contient du graphite, des métaux ou des oxydes de zinc ou d'étain additionnés, comme de l'oxyde d'étain additionné d'antimoine ou de l'oxyde de zinc additionné d'aluminium.

10. Cellule solaire selon une des revendications 1 à 9,
**caractérisée en ce que** le substrat de surface (S) est composé d'une matière poreuse dotée de pores qui constituent les structures d'ouvertures (O) traversant latéralement le substrat de surface (S).

11. Cellule solaire selon une des revendications 1 à 10,
**caractérisée en ce que** les structures d'ouvertures (O) comportent un diamètre d'ouvertures de l'ordre de 1 à 10 µm et les structures d'ouvertures voisines (O) se situent à une distance mutuelle de 10 à 100 µm ou
que les structures d'ouvertures (O) comportent un diamètre d'ouvertures de l'ordre de 0,1 à 1 µm et les structures d'ouvertures voisines (O) se situent à une distance mutuelle de 1 à 10 µm ou
que les structures d'ouvertures (O) comportent un diamètre d'ouvertures de l'ordre de 10 à 100 µm et les structures d'ouvertures voisines (O) se situent à une distance mutuelle de 100 à 500 µm ou
que les structures d'ouvertures (O) comportent un diamètre d'ouvertures de l'ordre de 5 à 25 µm et les structures d'ouvertures voisines (O) se situent à une distance mutuelle de 25 à 100 µm.

12. Cellule solaire selon une des revendications 1 à 11,
**caractérisée en ce que** la succession de couches se trouvant sur la face avant du substrat de surface (S), composée de la plage d'électrode (En), de la couche recevant les électrons (n), de la couche photovoltaïque (A), présente une épaisseur de couches globale inférieure à la moitié du diamètre d'ouvertures des structures d'ouvertures (O) ou, dans le cas où il est prévu en plus de la couche recevant les trous (p) une couche p⁺⁺, qu'il faut tenir compte pour l'épaisseur de couches globale précitée, de l'épaisseur de la couche recevant les trous (p).

13. Cellule solaire selon une des revendications 1 à 12,
**caractérisée en ce que** le substrat de surface (S) est composé d'une matière plastique poreuse, de textile ou de matière cellulosique, comme du papier, ou d'un film métallique traité en surface.

14. Cellule solaire selon une des revendications 1 à 13,
**caractérisée en ce que** le substrat de surface (S) est élastique.

15. Cellule solaire selon une des revendications 1 à 14,
**caractérisée en ce que** la couche photovoltaïque (A) contient de la matière à base de polymère ou des compositions de matières à base de polymère.

16. Cellule solaire selon une des revendications 1 à 15,
**caractérisée en ce que** la couche photovoltaïque (A) contient un mélange de dérivé de fullerène et d'un polymère de PPV.

17. Cellule solaire selon une des revendications 1 à 16,
**caractérisée en ce que** la couche recevant les électrons (n) est une couche de LiF ou une couche de bathophénantroline additionnée de Cs.

18. Cellule solaire selon une des revendications 1 à 17,
**caractérisée en ce que** les plages d'électrode (En, Ep) sont composées d'aluminium.

19. Cellule solaire selon le préambule de la revendication 1,
**caractérisée en ce que** la couche recevant les trous (p) est reliée par sa plage d'électrode (Ep) à un substrat de surface (S) présentant une face avant et une face arrière, que le substrat de surface (S) présente des structures d'ouvertures (O) traversant latéralement de la face avant vers la face arrière,
que la couche recevant les électrons (n), la couche photovoltaïque (A), la couche recevant les trous (p) ainsi que la plage d'électrode (Ep) reliée à la couche (p) sont appliquées sur la face avant du substrat de surface (S) de manière à ce qu'au moins certaines structures d'ouvertures traversent latéralement le substrat de surface (S) ainsi que le système de couches formé des couches Ep, p, A et n,
qu'une couche n⁺⁺ conductrice d'électricité est appliquée sur la couche recevant les électrons (n) ou que la couche recevant les électrons (n) est réalisée sous forme d'une couche n⁺⁺ qui remplit du moins partiellement les structures d'ouvertures (O) traversant latéralement le substrat de surface (S) jusqu'à la face arrière du substrat de surface (S) et
que la plage d'électrode (En) pour la couche recevant les électrons (n) est prévue sur la face arrière du substrat de surface (S) qui est en contact électrique avec la couche n⁺⁺ passant à travers les structures d'ouvertures (O).

20. Cellule solaire selon la revendication 19,
**caractérisée en ce que** les caractéristiques des revendications 2 à 7, 9 à 16 et 18 sont applicables individuellement ou combinées, de sorte que les matières de couches (n), (En), (p), (Ep), (p⁺⁺) conductrices d'électricité indiquées dans les revendications citées sont à inverser dans leur nature de conduction.

21. Procédé de fabrication d'une cellule solaire comportant au moins une couche photovoltaïque composée de matière organique, notamment de matière à base de polymère,
**caractérisé par** les étapes opératoires suivantes :
- préparation d'un substrat de surface (S) présentant une face avant et une face arrière qui comporte latéralement des structures d'ouvertures (O) traversant le substrat de surface (S) de la face avant à la face arrière,
- application d'une plage d'électrode (En) sur la face avant du substrat de surface (S),
- application surfacique d'une couche recevant des électrons (n) sur la plage d'électrode (En) sur la face avant du substrat de surface (S),
- application surfacique de la couche photovoltaïque (A) sur la couche recevant les électrons (n),
- application surfacique d'une couche recevant des trous (p) ou application d'une couche p⁺⁺ sur la couche photovoltaïque (A) ou application surfacique d'une couche p⁺⁺, dans le cas où il et prévu une couche recevant des trous (p), sur celle-ci de manière à ce que les structures d'ouvertures (O) traversant latéralement le substrat de surface (S) soient remplies jusqu'à la face arrière du substrat de surface (S) de matière de couche p⁺⁺ et
- application d'une autre plage d'électrode (Ep) sur la face arrière du substrat de surface (S), de manière à ce que la couche p⁺⁺ soit mise en contact avec l'autre plage d'électrode (Ep) par les structures d'ouvertures (O).

22. Procédé selon la revendication 21,
**caractérisé en ce qu'**en plus de la matière de couche p⁺⁺, on intègre dans les structures d'ouvertures une matière conductrice d'électricité, de sorte que celle-ci est mise en contact avec la couche p⁺⁺ et la plage d'électrode (Ep) sur la face arrière du substrat de surface (S).

23. Procédé selon une des revendications 21 ou 22,
**caractérisé en ce que** la plage d'électrode (En), la couche recevant des électrons (n), la couche photovoltaïque (A), la couche recevant des trous (p), la couche p⁺⁺ et/ou la plage d'électrode (Ep) sont appliquées par vaporisation, pulvérisation cathodique ou procédé de chimie humide.

24. Procédé selon une des revendications 21 à 23,
**caractérisé en ce que**, sur la face arrière du substrat de surface (S),
on applique un film avant que le substrat de surface (S) soit revêtu et que le film est enlevé de la face arrière du substrat de surface (S) avant l'application de l'autre plage d'électrode (Ep) sur la face arrière de celui-ci.

25. Procédé selon une des revendications 21 à 24,
**caractérisé en ce que** la mise en contact de la matière de couche p⁺⁺ se trouvant dans les structures d'ouvertures (O) traversant le substrat de surface (S) latéralement de la face avant à la face arrière par la plage d'électrode (Ep) de la face arrière du substrat de surface (S) est aidée par des pâtes, des vernis ou des solutions.

26. Procédé selon la revendication 25,
**caractérisé en ce que** les vernis, pâtes ou solutions sont conducteurs d'électricité et traversent du moins partiellement les structures d'ouvertures (O) et établissent une liaison conductrice d'électricité avec la couche p⁺⁺.

27. Procédé selon une des revendications 21 à 26,
**caractérisé en ce qu'**il est prévu sur et/ou dans la couche p⁺⁺ au moins une couche mince d'ITO (oxyde d'indium additionné d'étain) et/ou une couche inorganique transparente conductrice d'électricité.

28. Procédé selon la revendication 27,
**caractérisé en ce que** la couche d'ITO et/ou la couche inorganique transparente conductrice d'électricité est vaporisée ou pulvérisée.

29. Procédé selon une des revendications 21 à 28,
**caractérisé en ce que** l'application de la plage d'électrode (Ep) sur la face arrière du substrat de surface (S) est faite par vaporisation ou collage d'un film métallique.

30. Procédé selon la revendication 29,
**caractérisé en ce qu'**on utilise une colle conductrice d'électricité pour coller le film métallique.

31. Procédé selon la revendication 30,
**caractérisé en ce que** la colle conductrice d'électricité traverse du moins partiellement les structures d'ouvertures (O) et établit une liaison conductrice avec la couche p⁺⁺.

32. Procédé selon une des revendications 21 à 31,
**caractérisé en ce que** le substrat de surface (S) est préparé en le déroulant d'un premier rouleau et qu'après réalisation de toutes les étapes opératoires, les cellules solaires obtenues sur enroulées sur un deuxième rouleau.

33. Procédé selon le préambule de la revendication 21,
**caractérisé par** les étapes opératoires suivantes :
- préparation d'un substrat de surface (S) présentant une face avant et une face arrière, qui comporte latéralement des structures d'ouvertures (O) traversant le substrat de surface (S) de la face avant à la face arrière,
- application d'une plage d'électrode (En) sur la face avant du substrat de surface (S),
- application surfacique d'une couche recevant des trous (n) sur la plage d'électrode (En) sur la face avant du substrat de surface (S),
- application surfacique de la couche photovoltaïque (A) sur la couche recevant les trous (p),
- application surfacique d'une couche recevant les électrons (n) ou application d'une couche n⁺⁺ sur la couche photovoltaïque (A) ou application surfacique d'une couche n⁺⁺, dans le cas où il est prévu une couche recevant les électrons (n), sur celle-ci de manière à ce que les structures d'ouvertures (O) traversant latéralement le substrat de surface (S) soient remplies jusqu'à la face arrière du substrat de surface (S) de matière de couche n⁺⁺ et
- application d'une autre plage d'électrode (En sur la face arrière du substrat de surface (S), de manière à ce que la couche n⁺ soit mise en contact avec l'autre plage d'électrode (En) par les structures d'ouvertures (O).

34. Procédé selon la revendication 33,
**caractérisé en ce que** les caractéristiques des revendications 22 à 26 et 29 à 32 sont applicables de manière à ce que les matières de couches (n), (En), (p), (Ep), (p⁺⁺) conductrices d'électricité indiquées dans les revendications mentionnées soient à inverser dans leur structure de conduction.
